# EUROPÄISCHE PATENTANMELDUNG

(11) **EP 0 893 883 A2**
(43) Veröffentlichungstag der Anmeldung: **27.01.1999**
(21) Anmeldenummer: 98810626.6
(22) Anmeldetag: 06.07.1998
(51) Int. Cl.: H03K 17/73, H03K 17/723

(54) **Vorrichtung zum Begrenzen des Haltestromes eines Abschaltthyristors**

(30) Priorität: 24.07.1997 DE 19731835
(71) Anmelder: Asea Brown Boveri AG, 5401 Baden (CH)
(72) Erfinder: Coenraads, Ard, 5400 Baden (CH); Grüning, Horst, Dr., 5430 Wettingen (CH)
(74) Vertreter: Lück, Gert, Dr.

(57) **Zusammenfassung**

Es wird eine Vorrichtung zur Begrenzung des Haltestromes eines GTOs angegeben. Die Vorrichtung ist Teil einer Ansteuerschaltung zum Ein- und Ausschalten des GTOs und dadurch gekennzeichnet, dass ein Transistor in den Strompfad zwischen der Einschaltschaltung der Ansteuerschaltung und entweder dem Gate oder der Kathode des Abschaltthyristors geschaltet ist, wobei die Steuerelektrode des Transistors mit der Kathode bzw. dem Gate des Abschaltthyristors verbunden ist. Im ersten Fall handelt es sich vorzugsweise um einen pnp-Transistor im zweiten Fall um einen npn-Transistor.

## Beschreibung

### Technisches Gebiet

Die Erfindung bezieht sich auf das Gebiet der Leistungselektronik. Sie geht aus von einer Vorrichtung zum Begrenzen eines Haltestromes eines Abschaltthyristors nach dem Oberbegriff des unabhängigen Anspruches.

### Stand der Technik

Abschaltthyristoren oder GTOs benötigen einen nicht unerheblichen Haltestrom am Gate, um den eingeschalteten Zustand aufrecht zu erhalten. Bei GTOs höchster Leistung wie z.B. einem 3 kA/4.5 kV Typ werden beispielsweise zwischen 4 A und 8 A Haltestrom im eingeschalteten Zustand benötigt, damit die Einrastbedingungen auch nach Einbrüchen im Anodenstrom und nach Kommutiervorgängen zwischen dem GTO und der antiparallelen Diode zuverlässig wiederhergestellt wird. Zum Wiederaufkommutieren ist es zudem oft notwendig, einen erhöhten Stromstoss zur Verfügung zu stellen. Beim Stand der Technik wird zu diesem Zweck häufig erneut ein Einschaltpuls angelegt. Der Leistungsbedarf, das Bauvolumen und auch der Kühlungsbedarf der Ansteuerschaltungen wird dadurch deutlich vergrössert.

Gerade aber für sogenannt hart angesteuerte GTOs, wäre es wünschenswert, eine möglichst kompakte Ansteuerschaltung zur Verfügung zu haben, damit diese in unmittelbarer Nähe des GTOs angeordnet werden kann. Eine Ansteuerschaltung für hart angesteuerte GTOs wird in der Europäischen Patentanmeldung EP 0 489 945 A1 des gleichen Erfinders beschrieben. Bei der harten Ansteuerung eines Abschaltthyristors wird im Gegensatz zur konventionellen Ansteuerung ein höherer und sehr viel steilerer Strom zum Ausschalten des GTOs an das Gate angelegt wird. Ausserdem sind Mittel zum Erzeugen eines Einschaltstromes vorgesehen. Diese Mittel erzeugen einen Strom zum Einschalten des GTO und einen Haltestrom zum Aufrechterhalten des eingeschalteten Zustandes. Die Mittel umfassen jeweils Kondensatoren, in denen die notwendige Energie gespeichert wird und mit Hilfe von Schaltern bedarfsweise entnommen wird.

Aus der nicht vorveröffentlichten Deutschen Patentanmeldung mit dem Aktenzeichen 197 08 873.2, ebenfalls des selben Erfinders, ist ferner eine räumliche Anordnung für eine Ansteuereinheit bekannt. Um die harte Ansteuerung zu realisieren, sind nämlich Anordnungen mit sehr niederinduktivem Aufbau gefragt. Zu diesem Zweck wird in der nicht vorveröffentlichten Patentanmeldung vorgeschlagen, die Bauelement in unmittelbarer Nähe des GTO anzuordnen. Grosse Aufbauten komplizieren zudem durch die enge Verknüpfung mit dem GTO den gesamten Stromrichter bezüglich Stabilität und Gesamtbauvolumen. Deshalb ist insbesondere bei hart angesteuerten GTOs notwendig, die Ansteuerschaltungen klein, zuverlässig und mit hohen Wirkungsgrad versehen aufzubauen.

Im Besonderen, wenn der Strom im eingeschalteten Zustand auf die Antiparalleldiode kommutiert hat, liegt an der Anode des GTOs eine bezüglich der Kathode negative Spannung. Diese wird durch die innere Struktur auf das Gate übertragen. Aufgrund der negativen Spannung des Gate gegenüber der Kathode würde der Haltestrom in das Gate ohne geeignete Massnahmen ungehindert ansteigen.

### Darstellung der Erfindung

Aufgabe der Erfindung ist es deshalb, eine Vorrichtung zur Begrenzung des Haltestromes anzugeben, die einfach aufgebaut ist und trotzdem zuverlässig funktioniert. Ausserdem soll eine Ansteuerschaltung, zu der die Vorrichtung gehört, kompakt, zuverlässig und mit einem hohen Wirkungsgrad versehen aufgebaut sein. Diese Aufgabe wird durch die Merkmale des unabhängigen Anspruchs gelöst.

Die erfindungsgemässe Vorrichtung ist dadurch gekennzeichnet, dass ein Transistor in den Strompfad zwischen der Einschaltschaltung der Ansteuerschaltung und entweder dem Gate oder der Kathode des Abschaltthyristors geschaltet ist, wobei die Steuerelektrode des Transistors mit der Kathode bzw. dem Gate des Abschaltthyristors verbunden ist. Im ersten Fall handelt es sich vorzugsweise um einen pnp-Transistor im zweiten Fall um einen npn-Transistor.

Die Ansteuerschaltung umfasst eine Einschaltschaltung und eine Ausschaltschaltung. Der Einschaltstrom und der Haltestrom werden aus Spannungsimpulsen erzeugt, die mit Hilfe eines elektrischen Energiespeichers in Ströme umgewandelt werden. Schaltungstechnisch ist es von besonderem Vorteil, wenn die benötigten Spannungspulse derselben Energiequelle, bzw. demselben Energiespeicher entnommen werden wie der für die Erzeugung des Ausschaltstromes benötigte Puls. Der Haltestrom wird vorzugsweise durch Wiederholen von Spannungspulsen erzeugt. Die Wiederholfrequenz dieser Spannungspulse kann dann je nach Bedarf erhöht oder verringert werden. Insbesondere wenn die Gate-Kathoden-Spannung negativ wird, wird die Frequenz reduziert, um bei erneut positiver Spannung wieder erhöht zu werden. Eine erfindungsgemässe Ansteuerschaltung umfasst somit im Rahmen der Einschaltschaltung mindestens einen elektrischen Energiespeicher, der die Spannungspulse in Ströme umwandelt. Es können ein gemeinsamer Energiespeicher für den Einschaltstrom und für den Haltestrom oder auch getrennte Energiespeicher vorgesehen sein. Die Übertragung der benötigten Energie aus dem Energiespeicher der Ausschaltschaltung auf die Energiespeicher der Einschaltschaltung kann entweder mittels induktiver Kopplung oder mittels kapazitiver Kopplung erfolgen. Besonders bevorzugt wird eine Ansteuerschaltung, bei der die elektrische Speisung der benötigten Logikschaltungen und der anderen Bauteile auf dem erwähnten Energiespeicher der Ausschaltschaltung basiert.

Mit dem erfindungsgemässen Vorrichtung kann der Haltestrom insbesondere auch dann, wenn eine bezüglich der Kathode negative Spannung am Gate anliegt, zuverlässig und nahezu ohne Verluste begrenzt werden. Der Aufbau der erfindungsgemässen Vorrichtung ist sehr einfach. Der schaltungstechnische Aufwand einer nach der Erfindung aufgebauten Ansteuerschaltung kann somit äusserst gering gehalten werden. Damit ist es möglich, die Ansteuerschaltung sehr nahe beim GTO anzuordnen und die Induktivität wie gewünscht gering zu halten

Weitere vorteilhafte Ausführungsformen ergeben sich aus den entsprechenden abhängigen Ansprüchen.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Ein Schaltbild zur Erläuterung der Funktion einer Ansteuereinheit für einen GTO;
- **Fig. 2**: Ein Schaltbild einer Ausführungsform der Erfindung;
- **Fig. 3**: Ein Schaltbild einer weiteren Ausführungsform der Erfindung;
- **Fig. 4**: Ein Schaltbild einer dritten Ausführungsform der Erfindung;
- **Fig. 5**: Eine schematische Darstellung des Spannungspulses und des dadurch erzeugten Stromes;
- **Fig. 6**: Ein Schaltbild einer vierten Ausführungsform der Erfindung.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

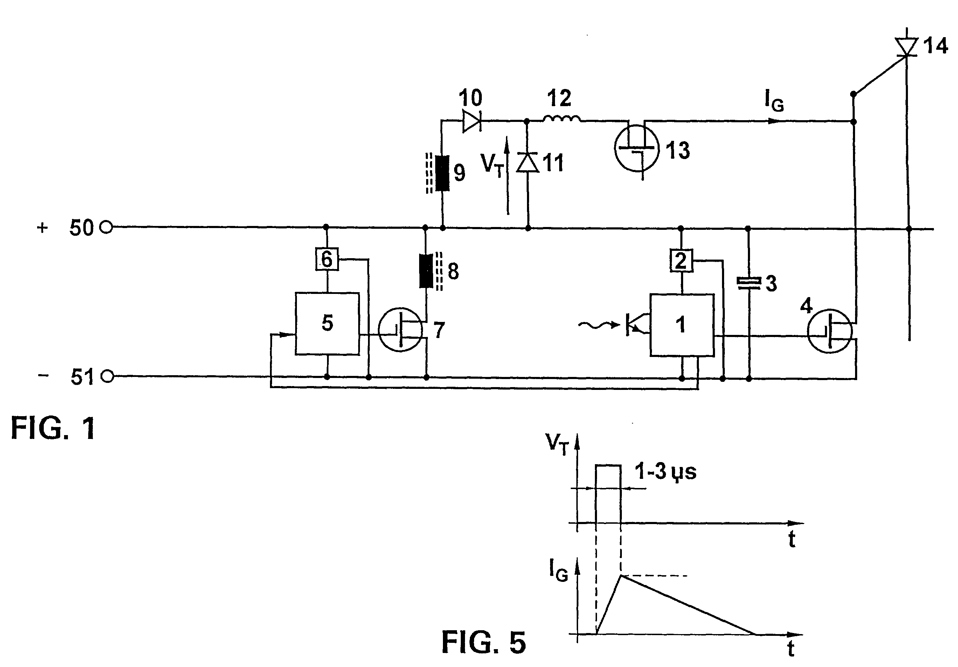

**Figur 1** zeigt ein Schaltbild einer Ansteuerschaltung für einen Abschaltthyristor 14. Mit 50 und 51 sind die Plus- und Minusanschlüsse einer Spannungsquelle mit z.B. 20 V Ausgangsspannung bezeichnet. Von dieser Spannungsquelle wird ein zu einer Ausschaltschaltung gehörender Energiespeicher 3 gespeist. Der Energiespeicher 3 kann insbesondere in Form einer Elektrolytkodensatorbank ausgebildet sein. Die Ansteuerschaltung umfasst neben der Ausschaltschaltung und eine Einschaltschaltung. Die Ausschaltschaltung wird im wesentlichen gebildet durch eine Ausschaltlogik 1, durch den Energiespeicher 3 und einen Schalter 4. Der Schalter 4 ist an das Gate des GTO 14 und an den Energiespeicher 3 angeschlossen und wird von der Ausschaltlogik 1 angesteuert. Die Ausschaltlogik 1 wird vorzugsweise von einem Längsregler 2 (ein handelsüblicher Spannungsregler) gespeist. Die benötigten Steuersignale empfängt die Ausschaltlogik 1 beispielsweise über einen Lichtwellenleiter, angedeutet durch den Pfeil und den Transistor am linken Rand des Blockes der Ausschaltlogik 1. Ein über den Lichtwellenleiter gesandter Befehl, den GTO 14 auszuschalten, wird in der Logik 1 verstärkt und bildet eine Spannung an dem Schalter 4, so dass dieser zu leiten beginnt. Aufgrund der Polarität des Energiespeichers 3 wird somit ein Strom aus dem Gate des GTOs 14 gezogen. Dadurch wird das Gate des GTOs gegenüber der Kathode negativ, und der GTO schaltet aus. Der Schalter 3 kann insbesondere auch eine Parallelschaltung von MOSFETs umfassen. Analoges gilt für den Energiespeicher 3, der aus eine Mehrzahl von parallel geschalteten EL-KOs bestehen kann.

Ausserdem ist eine Einschaltschaltung vorgesehen. Diese umfasst eine Einschaltlogik 5, die in gleicher Weise wie die Ausschaltlogik 1 von dem Energiespeicher 3 gespeist wird. Der entsprechende Längsregler ist mit 6 bezeichnet. Die beiden Logiken 1 und 5 sind signalmässig miteinander verbunden. Empfängt die Ausschaltlogik 1 einen Befehl zum Ausschalten des GTOs 14, so wird auf diese Weise eine Aktivierung der Einschaltlogik 5 unterbunden. Empfängt die Logik 1 jedoch einen Einschaltbefehl, so zwingt die Einschaltlogik 5 den von ihr angesteuerten Schalter 7 zum Takten. Der Schalter 7 ist ebenfalls zwischen den Anschlüssen 50 und 51 angeordnet. Die auf diese Weise erzeugten Spannungspulse werden mit Hilfe des zum Schalter 7 in Serie geschalteten Transformators 8, 9 zu einer Gleichrichter Diode 10 übertragen, die einen elektrischen Energiespeicher, vorzugsweise eine Induktivität 12 speist. Die Induktivität des Transformators 8, 9 sollte, um die ganze Anordnung wie gewünscht niederinduktiv zu halten, kleiner sein als die Induktivität 12. Dies kann baulich beispielsweise dadurch erreicht werden, dass die Spulen 8 und 9 auf der Platine integriert und mit einem Kern magnetisch gekoppelt werden. Je nach geforderter Grösse der Induktivität 12 kann auch sie als Leiterschleife auf der Platine integriert werden. Die Induktivität 12 ist über einen weiteren Schalter 13 mit dem Gate des GTO 14 verbunden. Der Schalter 13 trennt die Einschaltschaltung beim Ausschalten und im ausgeschalteten Zustand von dem Gate des GTO.

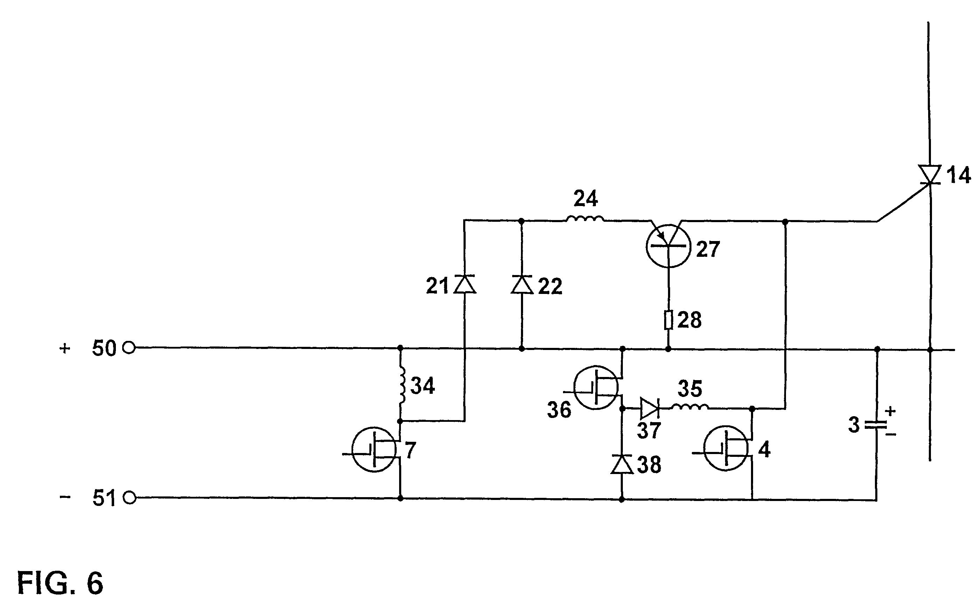

**Figur 5** zeigt einen solchen Spannungspuls V_{T}, der über den Transformator 8, 9 übertragen wird. Sekundärseitig wird der Spannungspuls durch die Diode 10 gleichgerichtet und in der Induktivität 12 in einen Strom umgewandelt. Über die zwischen Plusanschluss 50 und Kathode angeordnete Freilaufdiode 11 kann der Strom umschwingen. Der Strom durch die Induktivität 12 hat in erster Näherung eine Dreiecksform wie in Figur 5 dargestellt. Für einen 3 kA, 4.5 kV GTO werden zum Einschalten ca. 200 A bis 400 A benötigt, die während ca. 5 bis 15 µs aufrecht erhalten werden sollten. Daraus ergeben sich beispielhafte Werte für die Induktivität 12 im Bereich von 100 nH. Nach dem Einschalten benötigt der GTO 14 aber noch einen gewissen Haltestrom, um den eingeschalteten Zustand aufrecht zu erhalten. Am einfachsten kann dies dadurch erfolgen, dass der beschriebene Einschaltpuls mit einer bestimmten Frequenz f1 wiederholt wird.

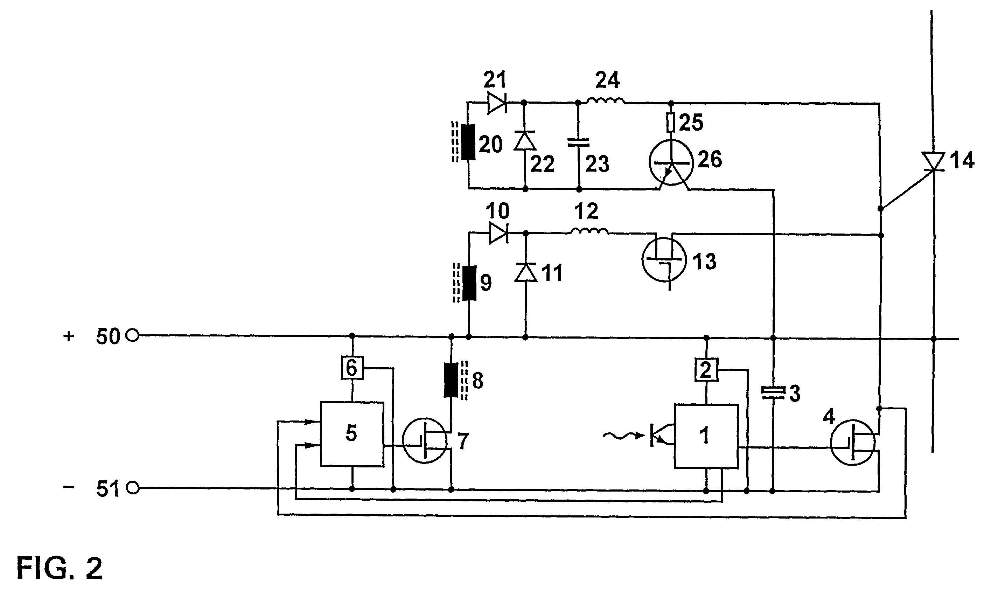

Der Strombedarf zum Zünden einerseits und zum Aufrechterhalten des gezündeten Zustandes andererseits ist sehr unterschiedlich. Zum Zünden sind für GTOs höchster Leistung wie erwähnt ca. 200 A notwendig, während der Haltestrom lediglich ca. 2 A betragen muss. Aus diesem Grund wäre es vorteilhaft, wenn der Haltestrom mit weniger Leistung erzeugt werden könnte als durch Wiederholen des Einschaltpulses. **Figur 2** zeigt ein Ausführungsbeispiel, das diesem Erfordernis gerecht wird. Es ist eine zweite Induktivität 24 vorgesehen, die ebenfalls über den Transformator via eine zweite Sekundärwicklung 20 gespeist wird. Die Gleichrichterdiode trägt die Bezugsziffer 21, die Freilaufdiode 22. Vorzugsweise ist parallel zu der Freilaufdiode 22 eine Kapazität 23 geschaltet. Die Kapazität 23 ermöglicht eine langsamere Energieentnahme, so dass die Wiederholfrequenz kleiner gehalten werden kann und der Haltestrom dennoch ausreichend gleichmässig ist. Dadurch kann die Induktivität 24 grösser gewählt werden als die Induktivität 12, z.B. im Bereich von 10 bis 50 µH. Anstelle einer zweiten Sekundärwicklung 22 kann auch ein eigener Transformator und eine eigene Logik vorgesehen sein. Bei dieser von der Erzeugung des Einschaltpulses getrennten Erzeugung des Haltestromes wird der Schalter 13 nach dem Zünden des GTO 14 geöffnet, so dass die Induktivität 12 vom Gate getrennt ist.

Im Falle der getrennten Erzeugung des Haltestromes sind zwischen das Gate und die Kathode des GTOs 14 aktive Stromanstiegsbegrenzungsmittel 25, 26 geschaltet sind. Eine erfindungsgemässe Vorrichtung zur Begrenzung des Haltestromes in jedem Betriebszustand umfasst einen Transistor 26, der im Falle der Figur 2 in den Strompfad zwischen Einschaltschaltung und Kathode geschaltet ist. Bevorzugt wird ein Emitterfolger mit einem Bipolartransistor 26 und einem Basisvorwiderstand 25. Diese Vorrichtung verhindert zuverlässig, dass der Haltestrom bei einer negativen Gate-Kathoden-Spannung ungehindert ansteigen kann. Bei einer negativen Spannung wird die Diode 22 nämlich leitend, und damit könnte der Strom ungehindert ansteigen. Dies wird durch die erfindungsgemässe Vorrichtung wirksam verhindert.

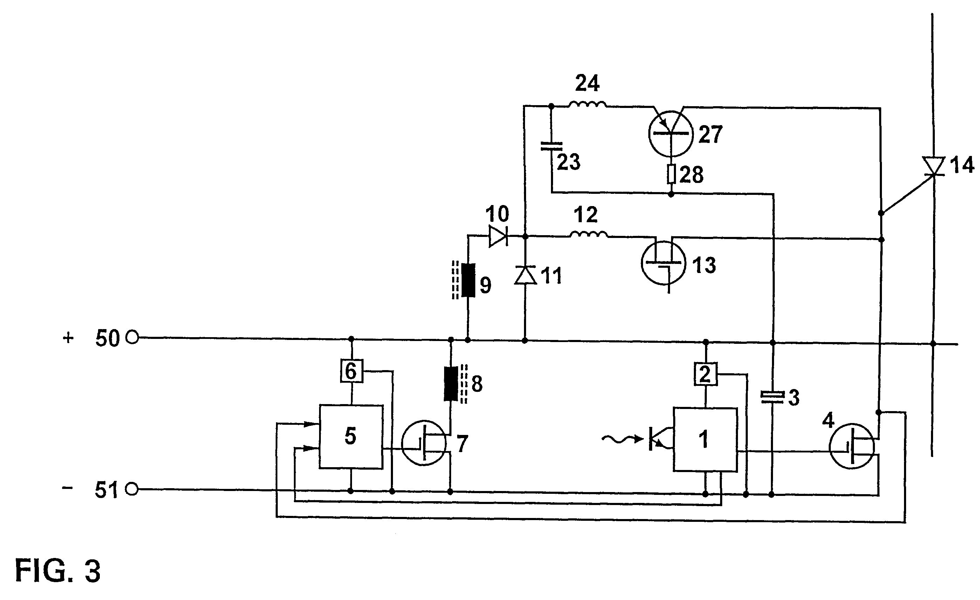

Der für die Erzeugung des Haltestromes benötigte Spannungspuls kann auch ohne eine zweite Sekundärwicklung direkt an der gleichgerichteten Spannung nach der Diode 10 abgegriffen werden. **Figur 3** zeigt ein entsprechenden Ausführungsbeispiel. Der gemeinsame Knotenpunkt der Gleichrichterdiode 10 und der Freilaufdiode 11 ist mit der zweiten Induktivität 24 verbunden. Die Stromanstiegsbegrenzungsmittel tragen die Bezugszeichen 27 für den Bipolartransistor und 28 für den Vorwiderstand. In diesem Ausführungsbeispiel wird ein Transistor umgekehrter Polarität verwendet, und der Transistor 27 ist in den Gatestrompfad geschaltet. Die Funktionsweise dieser Ausführungsform ist im wesentlichen dieselbe wie diejenige nach Figur 2. Sie funktioniert wie folgt: Bei positiver Gate-Kathoden-Spannung teilt sich der Strom aus der Induktivität 4 in einen Basisstrom und einen Kollektorstrom des Transistors 27. Der Basisstrom schaltet den Transistor durch. Somit wird die Induktivität 24 direkt mit dem Gate des GTO 14 verbunden. Bei negativer Gate-Kathoden-Spannung beginnt der Transistor zu regeln: Damit der Transistor einen Kollektorstrom führen kann, muss sein Emitter um die Flussspannung, d.h. ca. 0.7 V positiver sein als die Basis. Die in erster Näherung als Stromquelle zu betrachtende Induktivität 24 arbeitet aber weiterhin als Gegenspannung. Die Kollektrospannung wird negativ, sobald der Kommutierungsvorgang, d.h. der GTO 14 dies erzwingt. Trotzdem fliesst der Strom aus der Induktivität 24 zum grossen Teil weiter über die Emitter-Kollektor-Strecke. Dieser Strom wird wirksam begrenzt, weil der Transistor dies durch die Regelbedingung Uₑᵢₙ=U_{EB} + uR verhindert. Uₑᵢₙ bezeichnet die Spannung über der Induktivität, UEB die Emitter-Basis-Spannung und UR den Spannungsabfall am Basisvorwiderstand. Die Vorrichtung nach Figur 2 mit dem npn-Transistor 26 anstelle des erläuterten pnp-Transistors 27 funktioniert analog.

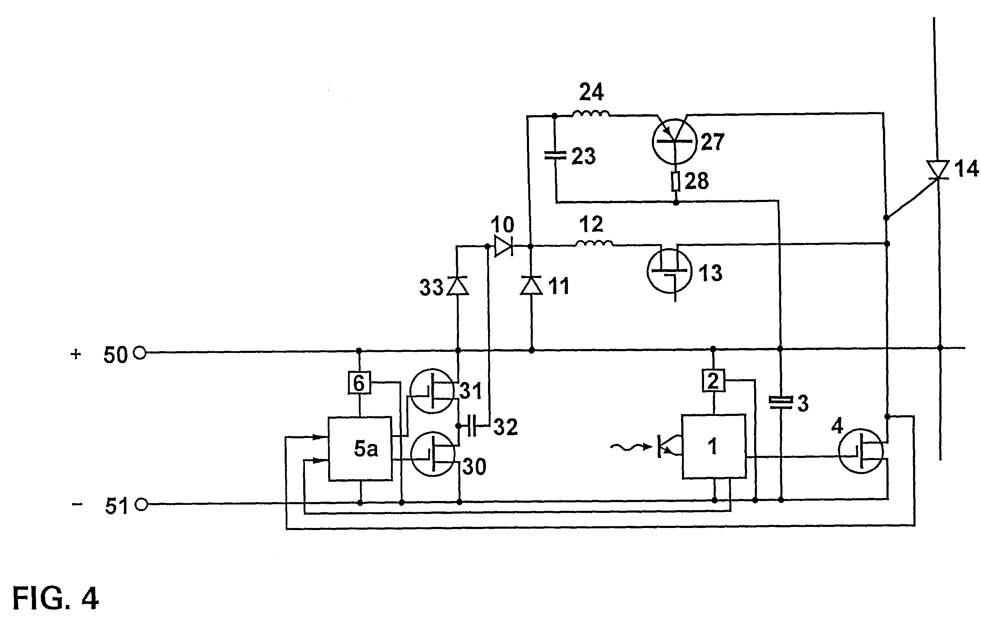

Anstelle einer induktiven Kopplung mit Hilfe eines Transistors ist auch eine kapazitive Kopplung mit Kondensatoren möglich. **Figur 4** zeigt ein entsprechendes Ausführungsbeispiel. Eine Einschaltlogik 5a steuert zwei zwischen den Anschlüssen 50 und 51 angeordnete Transistoren 31 und 30 an. Der Transistor 31 erzeugt einen positiven Spannungspuls, der Transistor 30 setzt wieder zurück. Über einen Koppelkondensator 32 wird der erzeugte Spannungspuls an die Gleichrichterdiode 10 weitergegeben. Ausserdem ist eine Rückladediode 33 vorgesehen, die zwischen der Kathode des GTO bzw. dem Plusanschluss 50 der Spannungsquelle und der Gleichrichterdiode 10 angeordnet ist. Im übrigen funktioniert die Schaltung nach Figur 4 wie die bereits weiter oben beschriebenen.

**Figur 6** zeigt eine Ausführungsform der Erfindung, bei der zur Erzeugung des Zündstromes die Ausschaltschaltung zu Hilfe genommen wird. Die Logiken 1 und 5 sind der Übersichtlichkeit halber nicht mehr dargestellt. Die Schaltung funktioniert wie folgt: Ein Ladetransistor 36 verbindet eine zuschaltbare Zündinduktivität 35 mit dem Plusanschluss 50 bevor der Ausschalttransistor 4 gesperrt wird. Infolgedessen baut sich in der Induktivität 35 ein Strom auf, der nach Sperren des Schalters 4 direkt auf das Gate kommutiert und so den geforderten Zündimpuls bildet. Die Induktivität 35 kann so gewählt werden, dass sich der Strom in ca. 5 bis 10 µs abbaut. Danach blockiert die der Induktivität 35 vorgeschaltete Ladediode 37, und der Ladetransistor 36 kann wieder gesperrt werden. Falls der Transistor 36 vor Abklingen des Stromes gesperrt wird, so kann die Restenergie über die Freilaufdiode 38 in den Energiespeicher 3 zurückgegeben werden. Auf diese Weise wird ein besonders kurzer und dennoch voll wirksamer Zündimpuls erzeugt. Der Teil der Einschaltschaltung, der für die Erzeugung des Haltestromes ausgebildet ist, kann wie bereits beschrieben aufgebaut sein, oder die benötigte Energie kann aus dem Energiespeicher 3 mittels einer Speicherinduktivität 34 und der Gleichrichterdiode 21 durch Taktung des Schalters 7 an den Energiespeicher 24 übergeben werden. Zum Ausschalten des GTOs 14 wird durch Betätigen des Schalters 4 aus dem Gate ein Strom gezogen.

In der vorstehenden Beschreibung wurden verschiedene Varianten der Energiekopplung und Speisung angegeben, die zwar nur anhand einzelner Figuren erläutert wurden, aber selbstverständlich fast beliebig miteinander kombinierbar sind, je nachdem, wo schaltungstechnisch ein Schwergewicht gebildet werden soll.

Die erläuterte Ansteuerschaltung ermöglicht eine Reduktion der Wiederholfrequenz f1 der Spannungspulse für den Haltestrom, sobald eine negative Gate-Kathoden-Spannung am GTO auftritt. In der Folge wird der auftretende Verlust im Bipolartransistor 26 oder 27 der Stromanstiegsbegrenzungsmittel insbesondere bei GTOs höchster Leistung, d.h. solchen mit einem hohen Bedarf an Haltestrom (> 1 A), reduziert. Die Wiederholfrequenz kann nach Wiederherstellen einer positiven Spannung zwischen Gate und Kathode des GTOs wieder erhöht werden. Dadurch erreicht man wieder einen höheren Gatestrom, so dass ein lückenloses Wiederaufkommutieren des GTOs sichergestellt wird. Ein Nachzündimpuls in der bisher üblichen Form wird dadurch überflüssig. Damit verschwindet auch die Gefahr, dass der Nachzündimpuls zum falschen Zeitpunkt auftritt und auch alle übrigen mit der genauen Detektion des korrekten Zeitpunktes des Nachzündens verbundenen Probleme. Ausserdem kann die EMV-Immunität der Anordnung auf diese Weise erhöht werden. Ganz allgemein kann der Gatestrom durch eine Beeinflussung der Wiederholfrequenz der Spannungspulse eingestellt werden.

Vorgängig wurde erläutert, dass der zur Erzeugung des Einschaltstromes bzw. des Haltestromes benötigte Spannungspuls demselben Energiespeicher 3 entnommen wird wie der für den Ausschaltstrom benötigte Impuls. Die Schaltung kann aber auch so aufgebaut sein, dass die Einschaltschaltung eine eigene Spannungsversorgung aufweist. Der Transformator 8, 9 würde in diesem Fall entfallen, dafür wäre mindestens eine weitere Versorgungsleitung und ein weiterer Energiespeicher notwendig.

Insgesamt erlaubt die erfindungsgemässe Vorrichtung, den Haltestrom zuverlässig zu beschränken. Eine mit dieser Vorrichtung ausgestattete Ansteuerschaltung weist einen kompakten und äusserst effizienten Aufbau auf, so dass die Schaltungsanordnung niederinduktiv wird. Somit ist die Schaltung auch für hart angesteuerte GTOs speziell geeignet.

### Bezugszeichenliste

- 1: Ausschaltlogik
- 2: Längsregler
- 3: Energiespeicher, Ausschaltkondensatorbank
- 4: Schalter
- 5, 5a: Einschaltlogik
- 6: Längsregler
- 7: Schalter
- 8: Primärwicklung des Transformators
- 9: Sekundärwicklung des Transformators
- 10: Gleichrichterdiode
- 11: Freilaufdiode
- 12: Speicherinduktivität
- 13: Schalter
- 14: GTO
- 20: Sekundärwicklung des Transformators
- 21: Gleichrichterdiode
- 22: Freilaufdiode
- 23: Speicherkondensator
- 24: Speicherinduktivität
- 25: Basiswiderstand
- 26: Bipolartransistor
- 27: Bipolartransistor
- 28: Basiswiderstand
- 30: Schalter
- 31: Schalter
- 32: Koppelkondensator
- 33: Rückladediode
- 34: Speicherinduktivität
- 35: Zündinduktivität
- 36: Ladetransistor
- 37: Ladediode
- 38: Freilaufdiode
- 50: Plusanschluss
- 51: Minusanschluss

- U_{EB}: Emitter-Basisspannung
- U_{R}: Spannung am Vorwiderstand 27
- V_{T}: Spannung an der Freilaufdiode 22
- I_{G}: Gatestrom

## Patentansprüche

1. Vorrichtung zum Begrenzen eines Haltestromes eines Abschaltthyristors (14), wobei die Vorrichtung Teil einer Ansteuerschaltung zum Ein- und Ausschalten des Abschaltthyristors (14) ist, welche Ansteuerschaltung eine Ausschaltschaltung und eine Einschaltschaltung umfasst und zwischen dem Gateanschluss und dem Kathodenanschluss des Abschaltthyristors (14) angeordnet ist, wobei die Einschaltschaltung zum Erzeugen eines Zündstromes und eines einen eingeschalteten Zustand des Abschaltthyristors (14) aufrechterhaltenden Haltestromes ausgebildet ist, dadurch gekennzeichnet, dass die Vorrichtung einen Transistor (26, 27) umfasst, der in den Strompfad zwischen der Einschaltschaltung und dem Gate oder der Kathode des Abschaltthyristors geschaltet und dessen Steuerelektrode mit der Kathode bzw. dem Gate des Abschaltthyristors wirkverbunden ist.

2. Vorrichtung nach Anspruch 1, dadurch gekennzeichnet, dass die Einschaltschaltung mindestens einen elektrischen Energiespeicher (12, 23, 24) umfasst, der Spannungspulse in den Einschaltstrom und den Haltestrom umwandelt.

3. Vorrichtung nach Anspruch 2, dadurch gekennzeichnet, dass die Ausschaltschaltung einen kapazitiven Energiespeicher (3) umfasst, aus dem Energie zur Erzeugung eines Ausschaltstromes mittels eines ersten Schalters (4) entnommen wird, dass die Einschaltschaltung einen zweiten Schalter (7) und mindestens einen Transformator (8, 9, 20), eine Koppelkapazität (32) oder eine Speicherinduktivität (34) umfasst, mittels derer zur Erzeugung des Einschaltstromes und des Haltestromes dem Energiespeicher (3) Spannungspulse entnommen und dem elektrischen Energiespeicher (12, 23, 24) der Einschaltschaltung zugeführt werden.

4. Vorrichtung nach Anspruch 3, dadurch gekennzeichnet, dass der elektrische Energiespeicher (12, 23, 24) der Einschaltschaltung eine erste Induktivität (12) umfasst, die über einen dritten Schalter (13) an das Gate des Abschaltthyristors (14) angeschlossen ist.

5. Vorrichtung nach Anspruch 4, dadurch gekennzeichnet, dass der elektrische Energiespeicher (12, 23, 24) der Einschaltschaltung eine zweite Induktivität (24) und eine Kapazität (23) mit paralleler Freilaufdiode (22) umfasst, welche Induktivität (24) an das Gate des Abschaltthyristors angeschlossen ist.

6. Vorrichtung nach Anspruch 5, dadurch gekennzeichnet, dass der Transformator (8, 9, 20) eine erste, die erste Induktivität (12) speisende Sekundärwicklung (9) und eine zweite, die zweite Induktivität (24) speisende Sekundärwicklung umfasst.

7. Vorrichtung nach Anspruch 2, dadurch gekennzeichnet, dass die Ausschaltschaltung einen kapazitiven Energiespeicher (3) umfasst, aus dem Energie zur Erzeugung eines Ausschaltstromes mittels eines ersten Schalters (4) entnommen wird, dass die Einschaltschaltung einen zweiten Schalter (7) und eine Speicherinduktivität (34) umfasst, mittels welcher zur Erzeugung des Haltestromes dem Energiespeicher (3) Spannungspulse entnommen und dem elektrischen Energiespeicher (12, 24) der Einschaltschaltung zugeführt werden, und dass die Einschaltschaltung zur Erzeugung des Zündstromes eine zuschaltbare Zündinduktivität (35) umfasst.
